# DEMANDE DE BREVET EUROPEEN

(11) **EP 0 632 465 A1**
(43) Date de publication de la demande: **04.01.1995**
(21) Numéro de dépôt: 94401456.2
(22) Date de dépôt: 28.06.1994
(51) Int. Cl.: G11C 17/18, H01L 23/62

(54) **Mémoire morte de faible capacité**

(30) Priorité: 29.06.1993 FR 9307897
(71) Demandeur: SOCIETE D'APPLICATIONS GENERALES D'ELECTRICITE ET DE MECANIQUE SAGEM, F-75783 Paris Cédex 16 (FR)
(72) Inventeur: Leleu, Joel, F-95459 Sagy (FR)
(74) Mandataire: Bloch, Gérard

(57) **Abrégé**

Mémoire morte pour la mémorisation du choix de fonctions électroniques par exemple dans un véhicule, comportant un circuit (2) d'écriture d'au moins un point mémoire (1). Le point mémoire (1) comporte un fusible sous forme de composant discret et que le circuit d'écriture (2) est agencé pour injecter dans le fusible (1) un courant de fusion.

## Description

Une mémoire morte sert à conserver des données en cas de disparition de l'alimentation électrique de cartes électroniques. Les données, qui sont par exemple un programme de microprocesseur, nécessitent en général une capacité mémoire relativement importante.

Il existe ainsi des mémoires EPROM et EEPROM qui peuvent être écrites au moyen d'un appareil spécifique et qui peuvent stocker, dans des points mémoires, des charges électriques correspondant à un état logique déterminé. De même, des mémoires de type FLASH permettent, lors de la disparition de l'alimentation, de sauvegarder des données dans une zone de mémoire morte.

Les mémoires ci-dessus présentent cependant l'inconvénient de nécessiter un appareil spécifique et d'utiliser des circuits complexes pour écrire dans les points mémoires.

La durée de vie de l'information est limitée car les points mémoires se déchargent lentement.

En outre, comme ces mémoires sont de forte capacité en nombre de points mémoires ou bits, et ont un boîtier coûteux, le coût unitaire du bit est prohibitif lorsqu'on souhaite disposer d'une mémoire de un ou quelques bits.

Or, dans une voiture par exemple, le constructeur peut offrir à l'acheteur des choix de personnalisation de la voiture, qui doivent ensuite rester mémorisés même après avoir coupé le contact.

C'est par exemple le cas pour le choix d'une langue parmi d'autres d'un synthétiseur vocal. L'acheteur doit donc pouvoir écrire quelques bits dans la mémoire morte sans l'enlever de l'ensemble qui la contient et qui utilise ses données, tandis que le coût de chaque bit doit rester limité.

A cet effet, la présente invention concerne une mémoire morte pour la mémorisation du choix de fonctions électroniques par exemple dans un véhicule, comportant un circuit d'écriture d'au moins un point mémoire, caractérisée par le fait que le point mémoire comporte un fusible sous forme de composant discret et que le circuit d'écriture est agencé pour injecter dans le fusible un courant de fusion.

On peut ainsi adapter le nombre voulu de fusibles en fonction des besoins. En outre, l'écriture d'un fusible peut être effectuée par l'utilisateur final puisque le circuit de commande comporte les moyens pour injecter le courant de fusion.

Avantageusement le circuit d'écriture est agencé pour injecter un courant de fusion prédéterminé.

On évite ainsi un appel de courant trop important sur l'alimentation des autres circuits de la carte portant la mémoire de l'invention, qui pourrait en particulier perturber un circuit externe commandant l'écriture dans la mémoire morte.

Avantageusement, le fusible est un composant à montage en surface. Le point mémoire est ainsi de faible taille et est peu coûteux au montage.

Avantageusement encore, il est prévu plusieurs fusibles et un circuit d'adressage pour relier l'un desdits fusibles au circuit d'écriture. On dispose alors de plusieurs points mémoires en conservant un unique circuit d'écriture.

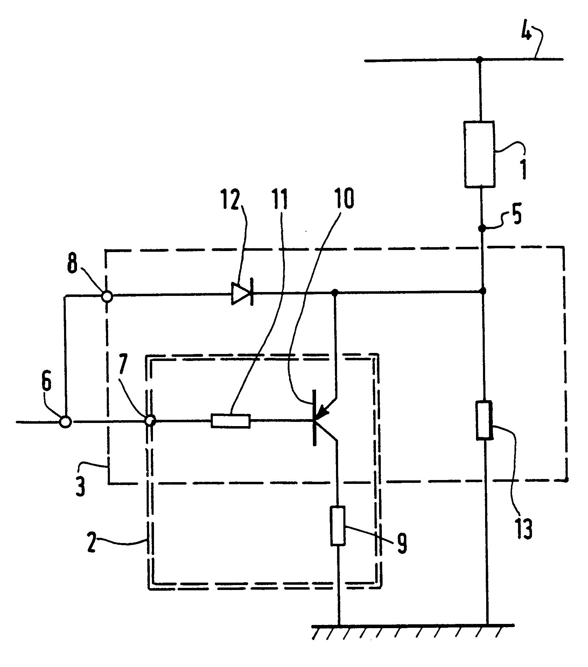

L'invention sera mieux comprise à l'aide de la description suivante de la forme de réalisation préférée de la mémoire morte à fusible de l'invention, en référence à son schéma électrique représenté sur la figure unique du dessin annexé.

La mémoire morte représentée comporte un seul point mémoire, un circuit d'écriture 2 et un circuit de lecture 3, délimités par deux cadres en pointillés sur la figure.

Le point mémoire est formé d'un fusible 1 constitué, ici, d'un composant discret à montage en surface (CMS). Le fusible 1 est relié par une borne à une liaison d'alimentation 4, ici à + 5 volts, et, par une borne opposée 5, au circuit d'écriture 2 et au circuit de lecture 3.

Les circuits 2 et 3 sont chacun reliés à la masse et, dans cet exemple, à une même borne 6 d'accès en écriture/lecture à la mémoire.

Le circuit d'écriture 2 est relié à la borne d'accès 6 par une borne 7, tandis que le circuit de lecture 3 est relié à la borne d'accès 6 par une borne de sortie 8.

Le circuit d'écriture 2 comporte une résistance 9, ici de 100 ohms, reliant à la masse le collecteur d'un transistor PNP, repéré 10, dont l'émetteur est relié à la borne 5.

La base du transistor 10 est reliée à la borne 7 par une résistance 11, d'environ 1 kilo-ohm.

Le circuit de lecture 3 comporte aussi le transistor 10 et la résistance 11. En plus, il comporte une diode 12 montée conductrice de la sortie 8 (borne 6) vers la borne 5 et une résistance 13 d' environ 40 kilo-ohms reliant à la masse la borne 5.

Le fonctionnement des circuits ci-dessus est le suivant.

En lecture, lorsque le fusible 1 est intact, le pont diviseur formé par le fusible 1 et la résistance 13 présente sur la borne 5 une tension voisine de celle de la liaison d'alimentation 4. Cette tension haute est transmise à la borne d'accès 6, servant alors de sortie, à travers la diode d'émetteur du transistor 10 et la résistance 11, qui sert à limiter le courant de lecture.

La borne d'accès 6 présente alors une tension voisine de celle présente sur la liaison d'alimentation 4.

Lorsque le fusible 1 a été détruit, comme expliqué plus loin, les circuits d'écriture 2 et de lecture 3 ne sont plus alimentés et le pont diviseur 1, 13 ne présente plus que la résistance 13 qui assure la polarisation, vers la masse, de la borne d'accès 6 à travers la diode 12.

La diode 12 sert aussi, dans cet exemple, à éviter que l'émetteur du transistor 10 présente une tension flottante lorsque le fusible 1 a été détruit, qui pourrait, pour une tension d'alimentation 4 élevée, endommager le transistor 10. Cependant, comme ce dernier ne servira plus, il est admissible qu'il soit détruit en circuit ouvert, ou en court-circuit shuntant la résistance 13.

De ce fait, la polarisation vers la masse de la borne d'accès 6 pourrait être assurée autrement, par exemple par une résistance reliant directement la borne d'accès 6 à la masse.

Pour écrire dans le point mémoire, une impulsion de tension d'écriture, vers la masse, est appliquée sur la borne d'accès 6 par un microprocesseur non représenté. Le transistor 10 est traversé par un courant de base provenant du fusible 1 et traversant la résistance 11, ce qui entraîne sa conduction émetteur-collecteur. La tension d'alimentation de la liaison 4 se retrouve alors pratiquement appliquée à la résistance 9 à travers le fusible 1 et le transistor 10. La valeur de la résistance 9 détermine la valeur du courant de fusion du fusible, ici 50 milliampères.

Dans le cas où le niveau de la tension d'écriture serait mal défini, il peut être introduit un circuit à seuil. Ce circuit à seuil peut être une résistance en parallèle avec la diode de la jonction émetteur-base du transistor 10 pour en détourner tout courant inférieur à un seuil déterminé.

Ce peut aussi être une diode, éventuellement zener, montée en série avec la résistance 11, afin de bloquer une partie de la tension de l'impulsion d'écriture.

Dans cet exemple, où les bornes 7 et 8 sont reliées, le circuit d'écriture 2 est non inverseur, de la borne 7 à la borne 5, afin d'éviter une auto-destruction du fusible 1 lors de sa lecture, car une tension haute sur la borne 6 ferait conduire, en l'absence de circuit à seuil, un transistor NPN inverseur. Dans le cas où les bornes 7 et 8 seraient distinctes électriquement, un circuit d'écriture inverseur pourrait être utilisé.

Dans le cas où la mémoire devrait comporter plusieurs points mémoire, plusieurs fusibles seraient utilisés et respectivement reliés, par leurs bornes 5, à des entrées d'un multiplexeur dont l'une, choisie par des entrées d'adressage du multiplexeur, pourrait être reliée à la sortie du multiplexeur, elle-même alimentant les circuits d'écriture 2 et de lecture 3 comme le fait la borne 5 de l'exemple décrit.

## Revendications

1. Mémoire morte pour la mémorisation du choix de fonctions électroniques par exemple dans un véhicule, comportant un circuit (2) d'écriture d'au moins un point mémoire (1), caractérisée par le fait que le point mémoire (1) comporte un fusible sous forme de composant discret et que le circuit d'écriture (2) est agencé pour injecter dans le fusible (1) un courant de fusion.

2. Mémoire selon la revendication 1, dans laquelle le circuit d'écriture (2) est agencé pour injecter un courant de fusion prédéterminé.

3. Mémoire selon l'une des revendications 1 et 2, dans laquelle le fusible (1) est un composant à montage en surface.

4. Mémoire selon l'une des revendications 1 à 3, dans laquelle il est prévu plusieurs fusibles et un circuit d'adressage pour relier l'un desdits fusibles (1) au circuit d'écriture (2).

5. Mémoire selon la revendication 4, dans laquelle le circuit d'écriture (2) comprend un étage de puissance (10) comportant un transistor agencé pour injecter le courant de fusion.

6. Mémoire selon la revendication 5, dans laquelle le circuit d'écriture (2) comporte un circuit à seuil agencé pour transmettre à une entrée de commande de l'étage de puissance (10), une partie d'un signal d'écriture de niveau supérieur à un seuil prédéterminé.

7. Mémoire selon la revendication 6, dans laquelle le circuit à seuil comporte une résistance pour dévier, de l'entrée de commande de l'étage de puissance (10), une partie du signal d'écriture.

8. Mémoire selon l'une des revendications 6 et 7, dans laquelle le circuit à seuil comporte une diode pour transmettre à l'entrée de commande de l'étage de puissance (10) ladite partie du signal d'écriture.

9. Mémoire selon la revendication 8, dans laquelle ladite diode est une diode zener.

10. Mémoire selon l'une des revendications 1 à 9, dans laquelle le fusible (1) est relié (12;10,11) à une borne d'entrée (7) du circuit d'écriture (2) par un circuit de lecture (3).
